# EUROPÄISCHE PATENTSCHRIFT

(11) **EP 1 854 214 B1**
(45) Veröffentlichungstag und Bekanntmachung des Hinweises auf die Patenterteilung: **13.04.2011**
(21) Anmeldenummer: 06707103.5
(22) Anmeldetag: 21.02.2006
(51) Int. Cl.: H03K 19/003

(54) **ELEKTRONIKBAUGRUPPE MIT ORGANISCHEN LOGIK-SCHALTELEMENTEN**
ELECTRONIC MODULE WITH ORGANIC LOGIC CIRCUIT ELEMENTS
MODULE ELECTRONIQUE A ELEMENTS LOGIQUES ORGANIQUES

(30) Priorität: 01.03.2005 DE 102005009820
(43) Veröffentlichungstag der Anmeldung: 14.11.2007
(73) Patentinhaber: PolyIC GmbH & Co. KG, 90763 Fürth (DE)
(72) Erfinder: ULLMANN, Andreas, 90513 Zirndorf (DE); KNOBLOCH, Alexander, 91054 Erlangen (DE); WELKER, Merlin, 91083 Baiersdorf (DE); FIX, Walter, 90427 Nürnberg (DE)
(74) Vertreter: Zinsinger, Norbert
(86) Internationale Anmeldenummer: PCT/EP2006/001523
(87) Internationale Veröffentlichungsnummer: WO 2006/092216

(56) Entgegenhaltungen:
- EP-A- 1 251 458
- BAUDE P F ET AL: "Organic semiconductor RFID transponders" INTERNATIONAL ELECTRON DEVICES MEETING 2003. IEDM. TECHNICAL DIGEST. WASHINGTON, DC, DEC 8 - 10, 2003, NEW YORK, NY : IEEE, US, 8. Dezember 2003 (2003-12-08), Seiten 191-194, XP010683989 ISBN: 0-7803-7872-5
- BAUDE P F ET AL: "Pentacene based RFID transponder circuitry" 21. Juni 2004 (2004-06-21), DEVICE RESEARCH CONFERENCE, 2004. 62ND DRC. CONFERENCE DIGEST [LATE NEWS PAPERS VOLUME INCLUDED] NOTRE DAME, IN, USA JUNE 21-23, 2004, PISCATAWAY, NJ, USA,IEEE, PAGE(S) 227-228 , XP010748228 ISBN: 0-7803-8284-6 das ganze Dokument
- MUKHERJEE S ET AL: "Layout-level synthesis of RF bandpass filter on organic substrates for wi-fi applications" 11. Oktober 2004 (2004-10-11), MICROWAVE CONFERENCE, 2004. 34TH EUROPEAN AMSTERDAM, THE NETHERLANDS 13 OCT. 2004, PISCATAWAY, NJ, USA,IEEE, PAGE(S) 1377-1380 , XP010788360 ISBN: 1-58053-992-0 das ganze Dokument

## Beschreibung

Die Erfindung betrifft eine Elektronikbaugruppe mit zwei oder mehr aus organischen Bauelementen, insbesondere organischen Feldeffekt-Transistoren aufgebauten Logik-Schaltelementen, die miteinander zu einer Logik-Schaltung verknüpft sind.

Logik-Schaltelemente wie beispielsweise NAND-Gatter, NOR-Gatter oder Inverter sind elementare Bestandteile einer digitalen elektronischen Schaltung. Die Schaltgeschwindigkeit der digitalen Schaltung hängt hierbei maßgeblich von der Schaltgeschwindigkeit der Logik-Schaltelemente ab, aus denen die digitale elektronische Schaltung zusammengesetzt ist.

In der herkömmlichen Silizium-Halbleitertechnologie werden Logik-Gatter durch Verwendung von n- als auch p-leitenden Transistoren realisiert, wodurch sich Gatter mit sehr hoher Schaltgeschwindigkeit realisieren lassen.

Weiter ist es bekannt, Logik-Gatter aus organischen Bauelementen aufzubauen. Üblicherweise wird hierbei ein herkömmlicher Widerstand anstelle des n-leitenden Transistors eingesetzt und die p-leitenden Transistoren durch organische Feldeffekt-Transistoren ersetzt. Nachteilig an diesen logischen Gattern mit organischen Feldeffekt-Transistoren ist, dass sie entweder eine geringe Umschaltgeschwindigkeit besitzen (wenn die Umladeströme, also die Integrale unter der Strom-Spannungskurve sehr verschieden sind) oder sich nicht ausschalten lassen (wenn der Spannungshub im Strom-Spannungsdiagramm zu gering ist).

In der Druckschrift von BAUDE P F ET AL: "Organic semiconductor RFID transponders" INTERNATIONAL ELECTRON DEVICES MEETING 2003. IEDM. TECHNICAL DIGEST. WASHINGTON, DC, DEC 8 - 10,2003, NEW YORK, NY : IEEE, US, 8. Dezember 2003 (2003-12-08), Seiten 191-194, XP010683989 ISBN: 0-7803-7872-5 wird ein Beispiel für eine Elektronikbaugruppe mit Filtereigenschaften aus organischen Halbleitern beschrieben.

Um die Schaltgeschwindigkeit von in organischer Halbleitertechnologie hergestellten digitalen Schaltungen zu erhöhen, wird in WO 2003/081 671 A3 vorgeschlagen, in Logik-Gattern den Widerstand durch einen zweiten organischen Feldeffekt-Transistor zu ersetzen, der als Widerstand eingesetzt wird. Hierzu werden organische Feldeffekt-Transistoren eingesetzt, die eine extreme dünne organische Halbleiterschicht (ca. 5 bis 30 nm) besitzen oder bei denen die Leitfähigkeit der organischen Halbleiterschicht durch gezielte Behandlung (beispielsweise Hydrazin-Behandlung und/oder gezielte Oxidation) soweit erniedrigt wurde, dass die Off Ströme nur um etwa eine Größenordnung unter den On-Strömen liegen.

Der Erfindung liegt nun die Aufgabe zugrunde, die mit einer aus organischen Bauelementen aufgebauten digitalen Schaltung erzielbare VerarbeitungsGeschwindigkeit weiter zu erhöhen.

Diese Aufgabe wird von einer Elektronikbaugruppe mit zwei oder mehr aus organischen Bauelementen aufgebauten organischen Logik-Schaltelementen, die miteinander zu einer Logik-Schaltung verknüpft sind, gelöst, bei der die Logik-Schaltung mindestens eine Filterbaugruppe aufweist, die einen mit einem der organischen Logik-Schaltelemente verbundenen Eingang und einen Ausgang aufweist und die die durch unterschiedliche Signallaufzeiten in den organischen Bauelementen der Logik-Schaltelemente erzeugten Signalstörungen aus dem am Eingang anliegenden Signal ausfiltert und am Ausgang ein regeneriertes binäres Signal bereit stellt.

Aufgrund der geringen Ladungsträger-Beweglichkeit der heute verfügbaren organischen Halbleiter und des andersartigen Funktionsprinzips organischer Feldeffekt-Transistoren sind die Schaltgeschwindigkeiten, die sich mit aus organischen Bauelementen aufgebauten digitalen Schaltungen erzielen lassen, um Größenordnungen kleiner als die, die in Silizium-Technologie aufgebaut sind.

Der Erfindung liegt die Erkenntnis zugrunde, dass bei Erhöhung der Taktrate in komplexeren organischen Schaltkreisen bei der Verknüpfung unterschiedlicher Signale, die von unterschiedlich vielen organischen Bauelementen verarbeitet wurden, Synchronisationsprobleme entstehen. Die Flanken des einen Signals sind gegenüber dem anderen zeitlich versetzt, wodurch bei einer Verknüpfung kurzzeitige Störungen im kombinierten Ausgangssignal auftreten. Diese Störspitzen sind für die weitere Verarbeitung des Signals sehr störend, da sich diese Fehler dann weiter anhäufen und infolge fälschlich als Teil des Nutzsignals interpretiert werden. Diese Störungen werden durch die oben beschriebene Filterbaugruppe entfernt. Dadurch wird es möglich, die digitale Schaltung mit einer höheren Taktrate zu betreiben und damit die Geschwindigkeit der Informationsverarbeitung zu erhöhen.

Vorteilhafte Ausgestaltungen der Erfindung sind in den Unteransprüche bezeichnet.

Als organische Logik-Schaltelemente, die zu der Logik-Schaltung verknüpft sind, können beispielsweise organische Logik-Gatter wie UND-Gatter, ODER-Gatter, NAND-Gatter, NOR-Gatter oder Inverter, aber auch komplexere organische Logik-Schaltelemente wie Schieberegister oder Addierer verwendet werden. Je nach Komplexität der Logik-Schaltung werden in die Logik-Schaltung ein oder mehrere Filterbaugruppen eingebunden, wobei sich durch Erhöhung der Anzahl der verwendeten Filterbaugruppen im Regelfall einer Erhöhung der Verarbeitungsgeschwindigkeit der digitalen Schaltung erzielen lässt. Die Filterbaugruppen können hierbei zwischen zwei organischen Logik-Schaltelementen geschaltet sein, so dass sowohl der Eingang der Filterbaugruppe als auch der Ausgang der Filterbaugruppe mit einem Logik-Schaltelement verbunden ist. Es ist jedoch auch möglich, die Filterbaugruppe an einem Ausgang der Logik-Schaltung anzuordnen, so dass lediglich der Eingang der Filterbaugruppe mit einem Logik-Schaltelement der Logik-Schaltung verbunden ist und der Ausgang der Filterbaugruppe mit einem Ausgang der Logik-Schaltung verbunden ist.

Bevorzugt wird die Filterbaugruppe mit dem Ausgang eines organischen Logik-Schaltelements verbunden, das mehrere über unterschiedliche Zweige der Logik-Schaltung generierte binäre Eingangssignale miteinander logisch zu einem Ausgangssignal verknüpft.

Gemäß eines bevorzugten Ausführungsbeispiels der Erfindung besteht die Filterbaugruppe aus einem Tiefpassfilter und einer nachfolgenden diskretisierenden Verstärkerschaltung. Der Tiefpassfilter ist hierbei zur Ausfilterung der durch unterschiedliche Signallaufzeiten in den organischen Bauelementen der vorgehenden Logik-Schaltelementen erzeugten Störungsspitzen ausgelegt. Die Grenzfrequenz des Tiefpassfilters wird so beispielsweise derart gewählt, dass die Amplitude der Störungsspitzen zwischen 50 und 70 % abgeschwächt wird. Die Störungsspitzen werden also einerseits von der nachfolgenden diskretisierenden Verstärkerschaltung eliminiert. Andererseits wird so die Verschiebung der Flanke eines nachfolgenden H-Pegels (H = High) des Nutzsignals minimal gehalten.

Vorzugsweise wird der Tiefpass als RC-Tiefpass aufgebaut und kann so kostengünstig in einer integrierten Schaltung realisiert werden.

Die Filterbaugruppe ist aus organischen Bauelementen aufgebaut. Bevorzugt besteht die Filterbaugruppe hierbei aus einem Widerstand und einer aus organischen Bauelementen aufgebauten diskretisierenden Verstärkerschaltung. Der RC-Tiefpass wird von dem Widerstand und der Eingangskapazität der Verstärkerschaltung gebildet. Bei einem besonders kostengünstigen Aufbau der Filterbaugruppe bildet der Widerstand und die Gate-Source-Kapazität des ersten organischen Feldeffekt-Transistors der Verstärkerschaltung hierbei den RC-Tiefpass. Diese beiden Bauelemente sind so gewählt, dass sich ein RC-Tiefpass mit einer Grenzfrequenz ergibt, die geeignet ist, die durch die unterschiedlichen Signallaufzeiten in den organischen Bauelementen der vorgehenden Logik-Schaltelemente erzeugten Störungsspitzen auszufiltern. Die Grenzfrequenz des Tiefpassfilters ist so in Abhängigkeit von den durch die unterschiedlichen Signallaufzeiten in den organischen Bauelementen der Logik-Schaltelemente erzeugten Störungsspitze zu wählen. Diese hängen zum einen von den vorgehenden Logik-Schaltelementen und der Verknüpfung dieser Logik-Schaltelemente und zum anderen von der Taktfrequenz ab, mit der die Logik-Schaltung betrieben wird, und können beispielsweise durch Messung oder Simulation bestimmt werden.

Eine derartige Filterbaugruppe kann mit einer geringen Anzahl von Bauelementen realisiert werden und ist demnach mit geringem Aufwand in eine Logik-Schaltung integrierbar.

Die Filterbaugruppe ist aus mehreren organischen Bauelementen aufgebaut, die derart verschaltet sind, dass die Filterbaugruppe den Pegel des am Eingang anliegenden Signals nur zu bestimmten, durch ein separates Taktsignal vorgegebenen Zeitpunkten an den Ausgang übernimmt und für die übrige Zeit den letzten vorausgegangenen Pegel am Ausgang beibehält. Das Taktsignal ist hierbei gegenüber dem Takt des am Eingang der Filterbaugruppe anliegenden Nutzsignals phasenverschoben. Die Phasenverschiebung ist hierbei so gewählt, dass die Filterbaugruppe zum Übemahmezeitpunkt keinesfalls ein Störsignal am Eingang vorfindet und somit einen korrekten Signalpegel übemimmt. Dieser wird dann von der Filterbaugruppe für den Rest der Taktperiode beibehalten, so dass am Ausgang ein Signal ohne Störungsspitzen entsteht.

Gute Ergebnisse lassen sich dadurch erzielen, dass die Phasenverschiebung des separaten Taktsignals gegenüber dem Takt des am Eingang anliegenden Signals zwischen 90 und 270° beträgt, vorzugsweise etwa 180° beträgt. Gemäß eines weiteren Ausführungsbeispiels der Erfindung wird die Phasenverschiebung so gewählt, dass die durch unterschiedliche Signallaufzeiten in den organischen Bauelementen der vorgehenden Logik-Schaltelemente erzeugten Störimpulse um mindestens 0,2 Periodenlängen von dem Übernahmezeitpunkt beabstandet sind. Hierzu ist es dann erforderlich, die Phasenlage der Störimpulse durch Messung oder durch Simulation zu ermitteln und eine Phasenverschiebung des separaten Taktsignals zu wählen, die dieser Beziehung entspricht.

Das separate Taktsignal für die Filterbaugruppe wird bevorzugt von einem aus organischen Feldeffekt-Transistoren aufgebauten Ringoszillator bereit gestellt. Bevorzugt wird das separate Taktsignal hierbei von dem Ringoszillator bereit gestellt, der das Taktsignals für die Logik-Schaltung generiert.

Das von dem Ringoszillator generierte Taktsignal kann hierbei über ein oder mehrere in Serie geschaltete Verzögerungsbauteile der Filterbaugruppe zugeführt werden, um auf diese Weise die gewünschte Phasenlage des separaten Taktsignals zu dem Nutzsignal am Eingang der Filterbaugruppe (stimmt aufgrund der Signallaufzeiten in der Regel nicht mit der Phasenlage des vom Ringoszillator generierten Taktsignals für die Logik-Schattung überein) zu erzielen.

Der Bauelementeaufwand lässt sich weiter dadurch reduzieren, dass der Ringoszillator, der aus mehreren ringförmig hintereinander verschalteten organischen Schaltelementen besteht, an einem ersten Ausgang eines ersten Schaltelements das Taktsignal für die Logik-Schaltung entnommen ist, und an einem Ausgang eines zweiten, dem ersten Schaltelement nachfolgenden Schaltelements das separate Taktsignal für die Filterbaugruppe entnommen ist. Auf diese Weise lassen sich auch zwei und mehr Filterbaugruppen mit zueinander phasenverschobenen, jeweils passenden separaten Taktsignalen mit sehr geringen Bauelemente-Aufwand versorgen.

Die erfindungsgemäße Elektronikbaugruppe kann für eine Vielzahl von Anwendungen eingesetzt werden. Besonders hervorzuheben ist hierbei der Einsatz der erfindungsgemäßen Elektronikbaugruppe als RFID-Transponder oder als Sicherungselement insbesondere zur Sicherung von Wertdokumenten und Waren. Die erfindungsgemäße Elektronikbaugruppe liegt hierbei bevorzugt in Form eines flexiblen Folienelements vor, das mittels einer Kleberschicht mit dem zu sichernden Objekt, beispielsweise einem Wertdokument, wie einem Reisepass oder einem Geldschein, verbunden ist.

Im Folgenden wird die Erfindung anhand von mehreren Ausführungsbeispielen unter Zuhilfenahme der beiliegenden Zeichnungen beispielhaft erläutert.
- Fig. 1: zeigt eine schematische Darstellung einer erfindungsgemäßen Elektronikbaugruppe.
- Fig. 2: zeigt ein Schaltbild einer Filterbaugruppe für die Elektronikbaugruppe nach Fig. 1.
- Fig. 3: zeigt mehrere Diagramme zur Verdeutlichung des Signalflusses in der Elektronikbaugruppe nach Fig. 1.
- Fig. 4: zeigt ein Schaltbild einer weiteren Ausführungsform einer Filterbaugruppe für die Elektronikbaugruppe nach Fig. 1.
- Fig. 5: zeigt mehrere Diagramme zur Verdeutlichung des Signalflusses in der Elektronikbaugruppe nach Fig. 1.
- Fig. 6: zeigt eine schematische Darstellung eines Ausschnitts einer weiteren erfindungsgemäßen Elektronikbaugruppe.

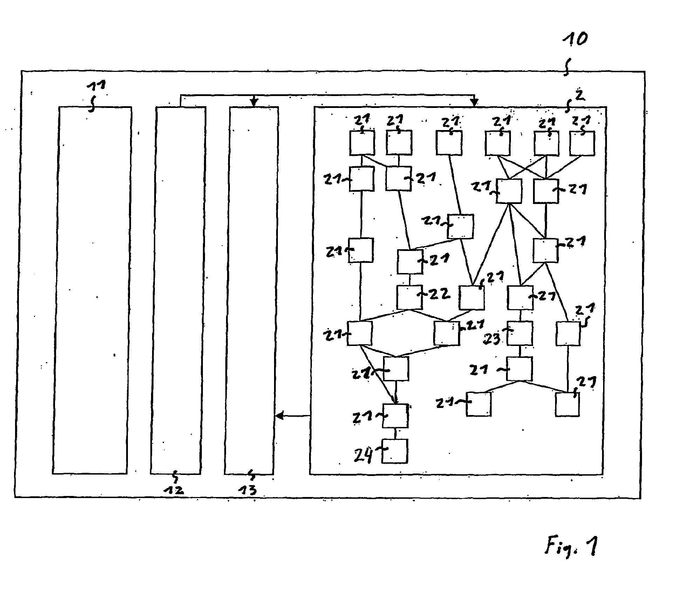

Fig. 1 zeigt eine Elektronikbaugruppe 10, die aus einem flexiblen, mehrschichtigen Folienkörper mit ein oder mehreren elektrischen Funktionsschichten besteht.

Die elektrischen Funktionsschichten des Folienkörpers bestehen aus (organisch) leitfähigen Schichten, organisch halbleitenden Schichten und/oder aus organischen Isolationsschichten, die zumindestens teilweise in strukturierter Form übereinander angeordnet sind. Neben diesen elektrischen Funktionsschichten umfasst den mehrschichtigen Folienkörper optional noch ein oder mehrere Trägerschichten, Schutzschichten, Dekorlagen, Haftvermittlungsschichten oder Kleberschichten. Die elektrisch leitfähigen Funktionsschichten bestehen vorzugsweise aus einer leitfähigen strukturierten Metallisierung, vorzugsweise aus Gold oder Silber. Es kann jedoch auch vorgesehen sein, diese Funktionsschicht aus einem anorganischen elektrisch leitfähigen Material auszubilden, beispielsweise aus Indium-Zinn-Oxid oder aus einen leitfähigen Polymer, beispielsweise aus Polyanilin oder Polypyrol, auszubilden. Die organisch halbleitende Funktionsschicht besteht beispielsweise aus konjugierten Polymeren, wie Polythiophenen, Polythlenylenvinylenen oder Polyfluorenderivaten, die als Lösung durch Spin-Coating, Raken oder Bedrucken aufgebaut werden. Als organische Halbleiterschicht eignen sich auch sogenannte "Small Moleküls", d. h. Oligomere wie Sexithiophen oder Pentacen, die durch eine Vakuumtechnik aufgedampft werden. Diese organischen Schichten werden bevorzugt durch en Druckverfahren (Tiefdruck, Siebdruck, Tampondruck) bereits partiell oder musterförmig strukturiert aufgebracht. Dazu sind die für die Schichten vorgesehenen organischen Materialien als lösbare Polymere ausgebildet, wobei der Begriff des Polymers hierbei, wie weiter oben bereits beschrieben, auch Oligomere und "Small Moleküls" einschließt.

Die elektrischen Funktionsschichten des Folienkörpers sind hierbei so ausgestaltet, dass sie die im Folgenden verdeutlichten elektrischen Schaltungen implementieren.

Bei der Elektronikbaugruppe 10 handelt es sich um einen RFID-Transponder mit einem Antennen-Schwingkreis 11, einem Gleichlichter 12, einem Modulator 13 und einer digitalen Logik-Schaltung 2. Es ist jedoch auch möglich, dass es sich bei der Elektronikbaugruppe 10 nach Fig. 1 um eine einem sonstigen Zweck dienende Elektronikbaugruppe handelt, die über eine digitale Logik-Schaltung verfügt. Aufgrund des Aufbaus der Elektronikbaugruppe 10 als flexibles mehrschichtiges Folienelement in polymerer Halbleitertechnologie eignet sich die Elektronikbaugruppe 10 hierbei besonders für Sicherheitsanwendungen und für Massenanwendungen. Neben den in Fig. 1 dargestellten Funktionsgruppen ist es für derartige Anwendungen von besonderem Vorteil, wenn die Elektronikbaugruppe 10 noch über ein in organischer Technologie gefertigtes Anzeigenelement, beispielsweise ein LC-Display aufweist, das von der Logik-Schaltung 2 angesteuert wird.

Die Logik-Schaltung 2 ist aus mehreren miteinander verknüpften Logik-Schaltelementen aufgebaut. Bei den einzelnen Logik-Schaltelementen handelt es sich beispielsweise um Logik-Gatter wie NOR- oder NAND-Gatter oder Inverter, oder auch um komplexere Logik-Schaltelemente, wie Schieberegister, Addierer usw. Die einzelnen Logik-Schaltelemente der Logik-Schaltung 2 sind hierbei bevorzugt wie in WO 03/081 671 A2 beschrieben aus organischen Feldeffekt-Transistoren aufgebaut, um eine möglichst hohe Schaltgeschwindigkeit der einzelnen Logik-Schaltelemente zu erzielen.

Fig. 1 zeigt einen Ausschnitt der Logik-Schaltung 2 mit mehreren Logik-Schaltelementen 21 und mehreren Filterbaugruppen 22, 23 und 24 die miteinander zur Erbringung einer Logik-Funktion verknüpft sind. Die Verknüpfung der Logik-Schaltelemente 21 nach Fig. 1 ist hierbei rein willkürlich lediglich zum Zwecke der Verdeutlichung der Erfindung gewählt und ist je nach der zu erzielenden Logik-Funktion zu wählen.

Zwischen die Logik-Schaltelemente 21 der Logik-Schaltung 2 sind, wie in Fig. 1 gezeigt, die Filterbaugruppen 22, 23 und 24 geschaltet. Die Filterbaugruppen 22, 23 und 24 verfügen über einen Eingang, der mit einem Ausgang eines der organischen Logik-Schaltelemente 21 verbunden ist und über einen Ausgang, der entweder mit einem Eingang eines weiteren der Logik-Schaltelemente 21 oder mit einem Ausgang der Logik-Schaltung 2 verbunden ist. Die Filterbaugruppen 22, 23 und 24 filtern jeweils die durch unterschiedliche Signallaufzeiten in den organischen Bauelementen der vorgehenden Logik-Schaltelemente erzeugten Signalstörungen aus dem am Eingang anliegenden Signal aus und stellen am Ausgang ein regeneriertes binäres Signal bereit.

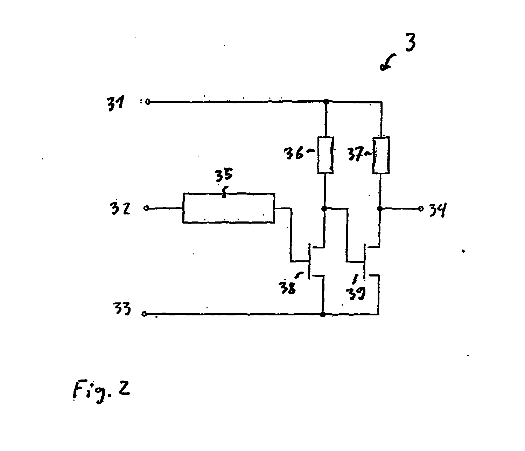

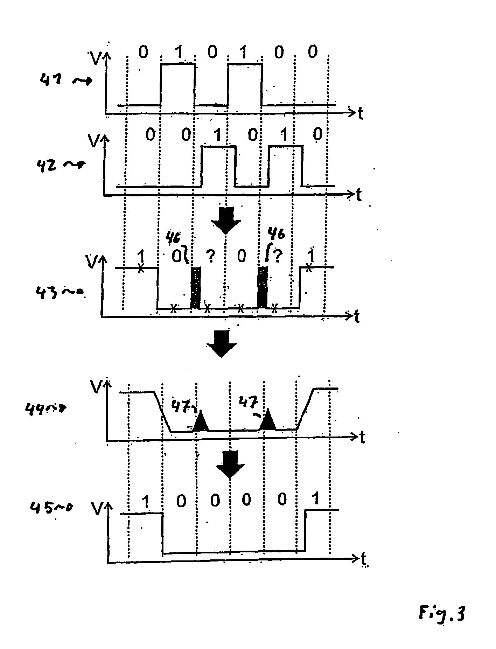

Die Filterbaugruppe 22 besteht beispielsweise aus einer elektronischen Schaltung 3, wie sie in Fig. 2 gezeigt ist. Die Funktionsweise der Filterbaugruppe 22 wird nun im Folgenden anhand von Fig. 3 verdeutlicht.

Fig. 3 zeigt mehrere Diagramme 41 bis 45, die jeweils den zeitlichen Verlauf eines Signalpegels V an einer Stelle der Logik-Schaltung 2 zeigen, d. h. der Signalpegel V ist gegenüber der Zeit t aufgetragen.

Die Diagramme 41 und 42 zeigen den zeitlichen Verlauf der Eingangssignale, die an den Eingängen des der Filterbaugruppe 22 vorangehenden Logik-Schaltelements anliegen. Das Diagramm 43 zeigt den zeitlichen Verlauf des am Ausgang dieses Logik-Schaltelements anliegenden Ausgangssignals. Bei dem Logik-Schaltelement handelt es sich hier beispielsweise um ein NOR-Gatter.

Der Takt des Nutzsignals an dem jeweiligen Punkt der Logik-Schaltung 2 ist in den Diagrammen 41 bis 45 durch gestrichelte Linien angedeutet, wobei hier auch zu beachten ist, dass sich dieser Takt aufgrund der Signallaufzeiten durch das Logik-Schaltelement und durch die Filterbaugruppe am Eingang und am Ausgang des Logik-Schaltelements und am Eingang und Ausgang der Filterbaugruppe 22 unterscheiden kann.

Aufgrund des Schaltverhaltens der organischen Bauelemente in den in den Diagrammen 41 bis 43 verdeutlichten logischen Schaltelement vorangehenden logischen Schaltelementen entsteht der in den Diagrammen 41 und 42 verdeutlichte zeitliche Versatz der an diesem logischen Schaltelement anliegenden EingangsSignalen. Werden die beiden Eingangssignale von dem logischen Schaltelement miteinander verknüpft, so entsteht das in Diagramm 43 angedeutete Ausgangssignal, welches Störimpulse 46 aufweist. Das durch die Störimpulse 46 gestörte Signal wird nun der Filterbaugruppe 22 zugeführt. Die Filterbaugruppe 22 unterdrückt alle Störungen, die deutlich kürzer sind, als die Taktzeit des Nutzsignals und gewinnt damit ein ungestörtes Ausgangssignal. Die Filterbaugruppe 22 ist aus einem Tiefpassfilter, der Taktimpulse abschwächt, die deutlich kürzer als die Taktzeit des Nutzsignals sind, und einer nachfolgenden diskretisierenden Verstärkerschaltung aufgebaut.

Die Filterbaugruppe 22 besteht so beispielsweise aus der in Fig. 2 gezeigten Schaltung 3 mit einem Widerstand 35, zwei organischen Feldeffekt-Transistoren 38 und 39 und zwei organischen Load-Elementen 36 und 37. Die organischen Feldeffekt-Transistoren 38 und 39 und die organischen Load-Elemente 36 und 37 bilden eine diskretisierende Verstärkerschaltung. Bei den organischen Load-Elementen 36 und 37 kann es sich um die in WO 03/981 671 A2 geschilderten speziellen organischen Feldeffekt-Transistoren handeln, die einen Widerstand nachbilden. Bei dem Widerstand 35 handelt es sich bevorzugt um einen organischen Widerstand. Die Schaltung 3 verfügt weiter über einen Anschluss 32 für das Eingangssignal, einen Anschluss 34 für das Ausgangssignal, einen Anschluss 31 für die Versorgungsspannung und einen Erdanschluss 33.

Der Widerstand 35 wird zusammen mit der Eingangskapazität der Verstärkerstufe als RC-Tiefpass verwendet, der die zeitlich relativ kurzen Störimpulse 46 deutlich abschwächt, das langsamere Nutzsignal aber nur geringfügig stört. Der RC-Tiefpass wird so durch den Widerstand 35 in Verbindung mit der Gate-Source-Kapazität des organischen Feldeffekt-Transistors 38 realisiert. Das am Ausgang des RC-Tiefpasses anliegende Signal ist in dem Diagramm 44 gezeigt. Die Störimpulse 46 werden durch den RC-Tiefpass zu den Störimpulsen 47 abgeschwächt. Die anschließende Verstärkerstufe stellt zum einen die Flankensteilheit des Nutzsignals, die im RC-Tiefpass verschlechtert worden ist, wieder her und entfernt andererseits durch die Diskretisierung auf zwei digitale Pegelwerte die abgeschwächten Störimpulse 47 vollständig aus dem Signal. Am Ausgang der Verstärkerstufe liegt dann das in dem Diagramm 45 gezeigte Signal an, aus dem die Störungen beseitigt wurden.

Die Grenzfrequenz des RC-Tiefpasses ist bevorzugt mindestens doppelt, bevorzugt 3-4 fach so groß wie die Taktfrequenz des Nutzsignals.

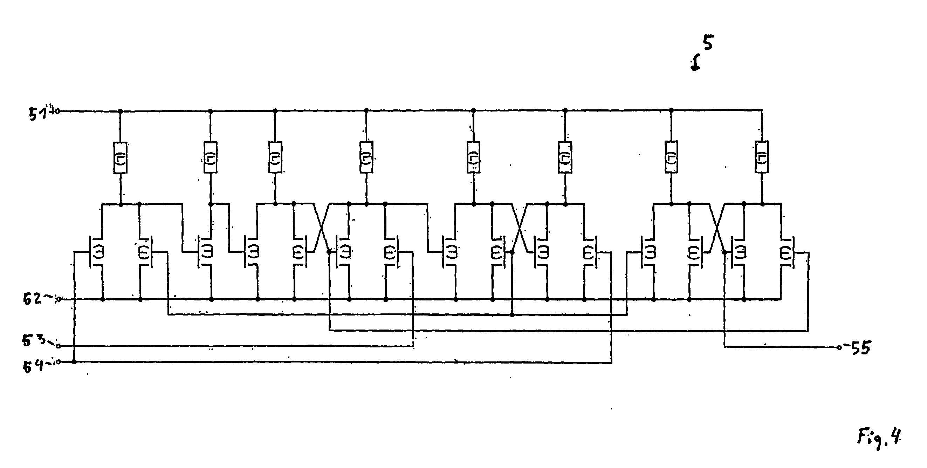

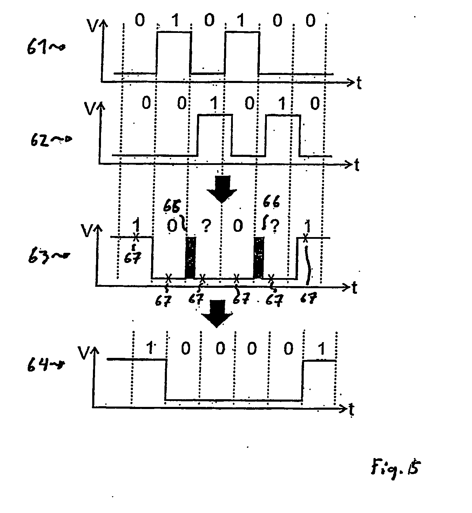

Die Filterbaugruppe 23 wird von einer in Fig. 4 gezeigten Schaltung 5 gebildet. Die Funktion der Filterbaugruppe 23 wird nun im Folgenden anhand der in Fig. 5 gezeigten Diagramme verdeutlicht.

Fig. 5 zeigt mehrere Diagramme 61 bis 64, die den zeitlichen Verlauf des Signalpegels an unterschiedlichen Stellen der Logik-Schaltung 2 verdeutlichen. In den Diagrammen 61 bis 64 ist hierbei der Signalpegel V gegenüber der Zeit t aufgetragen. Auch hier ist, wie in Fig. 3, der Takt des Nutzsignals durch gestrichelte Linien angedeutet.

Am Eingang der Filterbaugruppe 23 liegt das in dem Diagramm 63 verdeutlichte Signal an, welches durch Störimpulse 66 gestört ist. Die Störimpulse 66 entstehen hierbei, wie bereits oben anhand von Fig. 3 verdeutlicht, durch die durch das Schaltverhalten der organischen Bauelemente bedingten unterschiedlichen Signallaufzeit in den organischen Bauelementen der vorangehenden Logik-Schaltelemente.

Die Filterbaugruppe 23 unterdrückt nun die Störimpulse 66 und stellt am Ausgang das im Diagramm 64 gezeigte regenerierte binäre Signal bereit. Die Filterbaugruppe 23 übernimmt hierzu den Pegel des Eingangssignal nur zu bestimmten, durch ein separates Taktsignal, vorgegebenen Zeiten an den Ausgang. Für die übrigen Zeiten behält die Filterbaugruppe 23 den letzten, vorausgegangenen Pegel am Ausgang bei. Das Diagramm 63 zeigt so mehrere Zeitpunkte 67, die von dem separaten Taktsignal vorgegeben sind und an denen der Eingangs-Pegel von der Filterbaugruppe 23 an den Ausgang übernommen wird.

Durch eine geeignete Phasenverschiebung des Taktsignals, beispielsweise durch die im Diagramm 63 gezeigte Phasenverschiebung um 180°, wird erreicht, dass die Filterbaugruppe 23 zum Übemahmezeitpunkt keinesfalls ein Störsignal am Eingang vorfindet und somit den korrekten Signalpegel übernimmt. Wie in dem Diagramm 63 gezeigt, sind zu den Zeitpunkten 67 die Störimpulse 66 bereits abgeklungen, so dass dort der korrekte Signalpegel anliegt. Dieser Signalpegel wird dann von der Filterbaugruppe 23 auch für den Rest der Taktperiode beibehalten, so dass am Ausgang das in dem Diagramm 64 gezeigte Signal ohne Störungsspitzen entsteht.

Die in Fig. 4 gezeigte Schaltung 5 stellt eine mögliche Realisierung der Filterbaugruppe 23 in organischer Halbleitertechnologie dar. Die Schaltung 5 weist mehrere organische Feldeffekt-Transistoren T und mehrere organische Load-Elemente L auf, die miteinander wie in Fig. 4 gezeigt, verbunden sind. Die Schaltung 4 weist einen Anschluss 53 für das Eingangssignal, einen Anschluss 54 für das externe Taktsignal, einen Anschluss 55 für das Ausgangssignal, einen Anschluss 51 für die Versorgungsspannung und einen Erdanschluss 54 auf.

Das externe Taktsignal wird hierbei durch ein oder mehrere in Serie geschaltete Verzögerungsbauteile aus dem Takt des Nutzsignals gewonnen. Als Verzögerungsbauteile können beispielsweise aus organischen Bauelementen aufgebaute Inverter verwendet werden. In einer bevorzugten Ausführungsform der Erfindung wird das separate Taktsignal aus dem Taktsignal generiert, das den Verarbeitungs-Takt der Logik-Schaltung 2 vorgibt. Die Phasenlage dieses Taktsignals zu dem am Eingang der Filterbaugruppe 23 vorliegenden Takt des Nutzsignals sowie die gewünschte Phasenverschiebung des separaten Taktsignals gegenüber dem Takt des Nutzsignals ist zu bestimmen. Sodann wird eine entsprechende Anzahl von Verzögerungsbauteilen hintereinander verschaltet, um das gewünschte separate Taktsignal zu generieren.

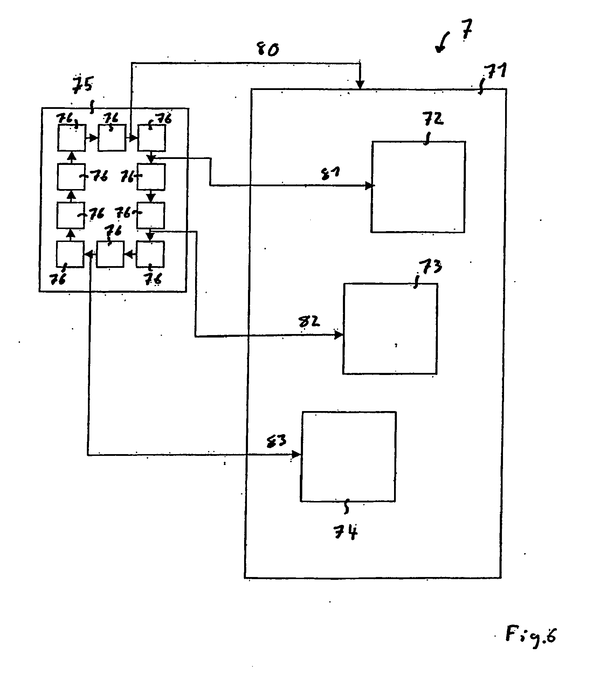

Eine weitere Möglichkeit der Generierung des separaten Taktsignals wird nun anhand des Ausführungsbeispiels nach Fig. 6 verdeutlicht:

Fig. 6 zeigt eine Elektronikbaugruppe 7 mit einer Logik-Schaltung 71 und einem Oszillator 75.

Die Logik-Schaltung 71 ist wie die Logik-Schaltung 2 nach Fig. 1 aufgebaut und verfügt über eine Vielzahl von miteinander verknüpften Logik-Schaltelementen. Im Weiteren sind mehrere Filterbaugruppen vorgesehen, die wie die Filterbaugruppe 23 nach Fig. 1 ausgestaltet sind. Von diesen Filterbaugruppen sind in Fig. 6 drei Filterbaugruppen 72, 73 und 74 gezeigt. Der Oszillator 75 stellt mehrere Taktsignale 80, 81, 82 und 83 bereit. Das Taktsignal 80 stellt das Taktsignal der Logik-Schaltung 71 dar und gibt die Schrittgeschwindigkeit der Verarbeitung von Informationen durch die Logik-Schaltung 71 vor. Die Taktsignale 81 bis 83 werden den Filterbaugruppen 72 bis 74 als separate Taktsignale zugeführt.

Der Oszillator 75 besteht aus einer Vielzahl von organischen Schaltelementen 76, die ringförmig hintereinander verschaltet sind. Bei den organischen Schaltelementen handelt es sich beispielsweise um aus organischen Feldeffekt-Transistoren aufgebauten Invertern. Wie in Fig. 6 gezeigt. werden die Taktsignal 80 bis 83 an den Ausgängen verschiedener organischer Schaltelemente 76 abgegriffen, so dass die Taktsignale 80 bis 83 gegeneinander phasenverschoben sind.

Wie bereits oben erläutert, wird so die Phasenverschiebung des jeweiligen separaten Taktsignals gegenüber dem Taktsignal 80 bestimmt und sodann dasjenige der organischen Schaltelemente 76 bestimmt, dessen Ausgangssignal den gewünschten Phasenversatz gegenüber dem am Abgriffspunkt des Taktsignals vorliegenden Signal besitzt.

## Patentansprüche

1. Elektronikbaugruppe (10, 7) mit zwei oder mehr aus organischen Bauelementen, insbesondere organischen Feldeffekt-Transistoren aufgebauten organischen Logik-Schaltelementen (21), die miteinander zu einer Logik-Schaltung (2, 71) verknüpft sind,
**dadurch gekennzeichnet,**
**dass** die Logik-Schaltung (2, 71) mindestens eine Filterbaugruppe (22, 3, 5, 72, 73, 74) aufweist, die einen mit einem der organischen Logik-Schaltelemente (21)verbundenen Eingang und einen Ausgang aufweist und so ausgestaltet ist, dass sie die durch unterschiedliche Signallaufzeiten in den organischen Bauelementen der Logik-Schaltelemente (21) erzeugten Signalstörungen aus dem am Eingang anliegenden Signal ausfiltert und am Ausgang ein regeneriertes binäres Signal bereit stellt, und dass die Filterbaugruppe (5, 72, 73, 74) mehrere organische Bauelemente (T) aufweist, die derart verschaltet sind, dass die Filterbaugruppe (5, 72, 73, 74) den Pegel des am Eingang (53) anliegenden Signals nur zu bestimmten, durch ein separates Taktsignal (81, 82, 83) vorgegebenen Zeitpunkten an den Ausgang (55) übernimmt und für die übrige Zeit den letzten vorgegangenen Pegel am Ausgang (55) beibehält, wobei das separate Taktsignal (81, 82, 83) gegenüber dem Takt des am Eingang (53) anliegenden Signals phasenverschoben ist.

2. Elektronikbaugruppe (10) nach Anspruch 1,
**dadurch gekennzeichnet,**
**dass** die Phasenverschiebung des separaten Taktsignals (81, 82, 83) gegenüber dem Takt des am Eingang (53) anliegenden Signals zwischen 90 und 270° beträgt, vorzugsweise etwa 180° beträgt.

3. Elektronikbaugruppe (10) nach Anspruch 1 oder Anspruch 2,
**dadurch gekennzeichnet,**
**dass** die Phasenverschiebung so gewählt ist, dass die durch unterschiedliche Signallaufzeiten in den organischen Bauelementen der vorgehenden Logik-Schaltelemente (21) erzeugten Störimpulse um mindestens 0,2 Periodenlängen von dem Übernahmezeitpunkt beabstandet sind.

4. Elektronikbaugruppe (7) nach einem der Ansprüche 1 bis 3,
**dadurch gekennzeichnet,**
**dass** die Elektronikbaugruppe (7) einen aus organischen Feldeffekt-Transistoren aufgebauten Ringoszillator (75) aufweist, der das separate Taktsignal (81, 82, 83) für die Filterbaugruppe (72, 73, 74) bereit stellt.

5. Elektronikbaugruppe nach Anspruch 4,
**dadurch gekennzeichnet,**
**dass** der Ringoszillator (75) das separate Taktsignal (81, 82, 83) für zwei oder mehr Filterbaugruppen (72; 73, 74) bereit stellt.

6. Elektronikbaugruppe (7) nach Anspruch 4 oder Anspruch 5,
**dadurch gekennzeichnet,**
**dass** der Ringoszillator (75) das Taktsignal (80) für die Logik-Schaltung (71) bereit stellt.

7. Elektronikbaugruppe (7) nach Anspruch 6,
**dadurch gekennzeichnet,**
**dass** der Ringoszillator (75) mehrere ringförmig hintereinander verschaltete organische Schaltelemente (76) aufweist, dass am Ausgang eines ersten der Schaltelemente (76) das Taktsignal (80) für die Logik-Schaltung (71) entnommen ist und dass am Ausgang eines zweiten, dem ersten Schaltelement nachfolgenden Schaltelements (76) das separate Taktsignal (81, 82, 83) für die Filterbaugruppe (72, 73, 74) entnommen ist.

8. Elektronikbaugruppe (7) nach Anspruch 7,
**dadurch gekennzeichnet,**
**dass** das zweite Schaltelement (76) an dessen Ausgang der Abgriff des separaten Taktsignal (81, 82, 83) erfolgt, aus der Anzahl der der Filterbaugruppe (72, 73, 74) vorangehenden Logik-Schaftelemente bestimmt ist.

9. Elektronikbaugruppe nach einem der Ansprüche 1 bis 8,
**dadurch gekennzeichnet,**
**dass** das Eingangs-Taktsignal der Logik-Schaltung ein oder mehreren seriell geschalteten Verzögerungsbauteilen zugeführt ist, die ausgangsseitig mit der Filterbaugruppe verbunden sind und das verzögerte Eingangs-Taktsignal der Filterbaugruppe als separates Taktsignal zuführen.

10. Elektronikbaugruppe (10) nach einem der vorgehenden Ansprüche,
**dadurch gekenntzeichnet,**
dass die Filterbaugruppe (22) mit dem Ausgang eines Logik-Schaltelements (21) verbunden ist, das mehrere über unterschiedliche Zweige der Logik-Schaltung (29) generierte binäre Eingangssignale miteinander logisch zu einem Ausgangssignal verknüpft.

11. Elektronikbaugruppe (10) nach einem der vorgehenden Ansprüche,
**dadurch gekennzeichnet,**
**dass** sowohl der Eingang als auch der Ausgang der Filterbaugruppe mit einem organischen Logik-Schaltelement verbunden ist.

12. Elektronikbaugruppe (10) nach einem der vorgehenden Ansprüche,
**dadurch gekennzeichnet,**
**dass** der Ausgang der Filterbaugruppe mit einem Ausgang der Logik-Schaltung verbunden ist.

13. Elektronikbaugruppe (10, 7) nach einem der vorgehenden Ansprüche,
**dadurch gekennzeichnet,**
**dass** die Logik-Schaltung (2, 71) zwei oder mehr Filterbaugruppen (22, 72, 73, 74) aufweist.

14. Elektronikbaugruppe (10) nach einem der vorgehenden Ansprüche,
**dadurch gekennzeichnet,**
**dass** die Elektronikbaugruppe ein RFID- Transponder ist.

15. Elektronikbaugruppe nach einem der Ansprüche 1 bis 14,
**dadurch gekennzeichnet,**
**dass** die Elektronikbaugruppe ein flexibles Folienelement ist, das als Sicherungselement insbesondere für Wertdokumente und Ware dient.

## Claims

1. Electronic module (10, 7) having two or more organic logic circuit elements (21) connected together to give a logic circuit (2, 71), said organic logic circuit elements being made up of organic components, in particular organic field effect transistors,
**characterized in that**
the logic circuit (2, 71) comprises at least one filter module (22, 3, 5, 72, 73, 74), which has an input connected to one of the organic logic circuit elements (21), and an output, and is designed to filter out from the signal present at the input the spurious signals generated by different signal propagation times in the organic components of the logic circuit elements (21), and to provide a regenerated binary signal at the output, and **in that** the filter module (5, 72, 73, 74) is made up of a plurality of organic components (T), which are connected together so that the filter module (5, 72, 73, 74) only transfers the level of the signal present at the input (53) to the output (55) at specific points in time set by a separate clock signal (81, 82, 83), and for the rest of the time retains the last previous level at the output (55), where the separate clock signal (81, 82, 83) is phase-shifted with respect to the clock of the signal present at the input (53).

2. Electronic module (10) according to Claim 1,
**characterized in that**
the separate clock signal (81, 82, 83) is phase-shifted with respect to the clock of the signal present at the input (53) by between 90 and 270°, preferably by about 180°.

3. Electronic module (10) according to Claim 1 or 2,
**characterized in that**
the phase shift is selected so that the glitches produced by different signal propagation times in the organic components of the preceding logic circuit elements (21) lie at least 0.2 period lengths away from the time of the transfer.

4. Electronic module (7) according to any of Claims 1 to 3,
**characterized in that**
the electronic module (7) comprises a ring oscillator (75) made up of organic field effect transistors, which provides the separate clock signal (81, 82, 83) for the filter module (72, 73, 74).

5. Electronic module according to Claim 4,
**characterized in that**
the ring oscillator (75) provides the separate clock signal (81, 82, 83) for two or more filter modules (72, 73, 74).

6. Electronic module (7) according to Claim 4 or 5,
**characterized in that**
the ring oscillator (75) provides the clock signal (80) for the logic circuit (71).

7. Electronic module (7) according to Claim 6,
**characterized in that**
the ring oscillator (75) comprises a plurality of organic circuit elements (76) chained together in a ring one after another, that the clock signal (80) for the logic circuit (71) is taken from the output of a first circuit element of the circuit elements (76), and that the separate clock signal (81, 82, 83) for the filter module (72, 73, 74) is taken from the output of a second circuit element (76) after the first circuit element.

8. Electronic module (7) according to Claim 7,
**characterized in that**
the second circuit element (76) at whose output the separate clock signal (81, 82, 83) is picked off, is determined from the number of logic circuit elements preceding the filter module (72, 73, 74).

9. Electronic module according to any of Claims 1 to 8,
**characterized in that** the input clock signal of the logic circuit is supplied to one or more series-connected delay elements, which are connected on their output side to the filter module, and which supply the delayed input clock signal to the filter module as a separate clock signal.

10. Electronic module (10) according to any of the preceding claims,
**characterized in that**
the filter module (22) is connected to the output of a logic circuit element (21) that combines by a logic operation a plurality of binary input signal generated via different branches of the logic circuit (29) to produce an output signal.

11. Electronic module (10) according to any of the preceding claims,
**characterized in that**
both the input and the output of the filter module are connected to an organic logic circuit element.

12. Electronic module (10) according to any of the preceding claims,
**characterized in that**
the output of the filter module is connected to an output of the logic circuit.

13. Electronic module (10, 7) according to any of the preceding claims,
**characterized in that**
the logic circuit (2, 17) comprises two or more filter modules (22, 72, 73, 74).

14. Electronic module (10) according to any of the preceding claims,
**characterized in that**
the electronic module is an RFID transponder.

15. Electronic module according to any of Claims 1 to 14,
**characterized in that**
the electronic module is a flexible foil element used as a security element, in particular for important documents and goods.

## Revendications

1. Module électronique (10, 7) ayant deux composants organiques ou plus, en particulier des éléments logiques organiques composés de transistors à effet de champ organiques, qui sont reliés entre eux par un circuit logique (2, 71),
**caractérisé**
**en ce que** le circuit logique (2, 71) comporte au moins un module de filtre (22, 3, 5, 72, 73, 74) qui comporte une entrée, reliée avec un des éléments logiques organiques (21), et une sortie et qui est agencé de sorte qu'il filtre dans le signal présent en entrée les perturbations de signal générées par les différents temps de propagation de signal dans les composants organiques des éléments logiques (21) et qu'il fournisse à la sortie un signal binaire régénéré, et en ce que le module de filtre (5, 72, 73, 74) comporte plusieurs composants organiques (T) qui sont montés de sorte que le module de filtre (5, 72, 73, 74) prenne à la sortie (55) le niveau du signal présent sur l'entrée (53) uniquement à certains instants prédéfinis par un signal d'horloge séparé (81, 82, 83) et garde le dernier niveau précédent à la sortie (55) pendant le reste du temps, le signal d'horloge séparé (81, 82, 83) étant décalé en phase par rapport à la cadence d'horloge du signal présent à l'entrée (53).

2. Module électronique (10) selon la revendication 1,
**caractérisé en ce que**
le décalage de phase du signal d'horloge séparé (81, 82, 83) par rapport à la cadence d'horloge du signal présent à l'entrée (53) est situé entre 90 et 270°, de préférence est égal à 180°.

3. Module électronique (10) selon la revendication 1 ou la revendication 2,
**caractérisé en ce que**
le décalage de phase est choisi de sorte que les impulsions perturbatrices générées par les différents temps de propagation de signal dans les composants organiques des éléments logiques précédents (21) soient distantes d'au moins 0,2 longueurs de période depuis l'instant de réception.

4. Module électronique (7) selon l'une des revendications 1 à 3,
**caractérisé en ce que**
le module électronique (7) comporte un oscillateur en anneau (75), qui est composé de transistors à effet de champ organiques et qui fournit le signal d'horloge séparé (81, 82, 83) pour le module de filtre (72, 73, 74).

5. Module électronique selon la revendication 4,
**caractérisé en ce que**
l'oscillateur en anneau (75) prépare le signal d'horloge séparé (81, 82, 83) pour au moins deux modules de filtre (72; 73, 74).

6. Module électronique (7) selon la revendication 4 4 ou la revendication 5,
**caractérisé en ce que**
l'oscillateur en anneau (75) prépare le signal d'horloge (80) pour le circuit logique (71).

7. Module électronique (7) selon la revendication 6,
**caractérisé en ce que**
l'oscillateur en anneau (75) comporte plusieurs éléments logiques organiques (76) montés les uns derrière les autres en forme d'anneau, **en ce que** le signal d'horloge (80) pour le circuit logique (71) est pris à la sortie d'un premier élément des éléments logiques (76) et **en ce que** le signal d'horloge séparé (81, 82, 83) pour le module de filtre (72, 73, 74) est pris à la sortie d'un deuxième élément logique (76) suivant le premier élément logique.

8. Module électronique (7) selon la revendication 7,
**caractérisé en ce que**
le deuxième élément logique (76) à la sortie duquel a lieu la prise du signal d'horloge séparé (81, 82, 83), est déterminé à partir du nombre des éléments logiques qui précèdent le module de filtre (72, 73, 74).

9. Module électronique selon l'une des revendications 1 à 8,
**caractérisé en ce que**
le signal d'horloge d'entrée du circuit logique est amené à un ou plusieurs composants retardateurs montés en série qui sont reliés en sortie avec le module de filtre et **en ce que** le signal d'horloge d'entrée retardé est amené au module de filtre en tant que signal d'horloge séparé.

10. Module électronique (10) selon l'une quelconque des revendications précédentes,
**caractérisé en ce que**
le module de filtre (22) est relié à la sortie d'un élément logique (21) qui combine plusieurs signaux d'entrée binaires, générés par différentes branches du circuit logique (29), logiquement entre eux en un signal de sortie.

11. Module électronique (10) selon l'une quelconque des revendications précédentes,
**caractérisé en ce que**
l'entrée ainsi que la sortie du module de filtre sont reliées à un élément logique organique.

12. Module électronique (10) selon l'une quelconque des revendications précédentes, **caractérisé en ce que** la sortie du module de filtre est reliée à une sortie du circuit logique.

13. Module électronique (10, 7) selon l'une quelconque des revendications précédentes,
**caractérisé en ce que**
le circuit logique (2, 71) comporte deux modules de filtre (22, 72, 73, 74) ou plus.

14. Module électronique (10) selon l'une quelconque des revendications précédentes,
**caractérisé en ce que**
le module électronique est un transpondeur RFID.

15. Module électronique selon l'une des revendications 1 à 14,
**caractérisé en ce que**
le module électronique est un élément de film flexible qui sert d'élément de sécurité, en particulier pour des documents de valeur et des marchandises.
